Europäisches Patentamt

European Patent Office

Office européen des brevets

(11) Publication number: **0 512 679 A2**

# EUROPEAN PATENT APPLICATION

(21) Application number: **92302810.4**

(22) Date of filing: **31.03.92**

(51) Int. Cl.5: **H01L 39/24**

(30) Priority: **02.05.91 US 695492**

(43) Date of publication of application:
**11.11.92 Bulletin 92/46**

(84) Designated Contracting States:
**DE GB NL**

(71) Applicant: **GENERAL ELECTRIC COMPANY**
**1 River Road**
**Schenectady, NY 12345(US)**

(72) Inventor: **Savkar, Sudhir Dattatraya**
**2344 Jade Lane**
**Schenectady, New York 12309(US)**
Inventor: **Penney, Carl Murray**
**Route 9P, Box 362A, RD 1**
**Saratoga Springs, New York 12866(US)**

(74) Representative: **Pratt, Richard Wilson et al**
**London Patent Operation G.E. Technical**
**Services Co. Inc. Essex House 12/13 Essex**
**Street**
**London WC2R 3AA(GB)**

(54) Method of making laser ablated oriented films on metal substrates and articles formed thereby.

(57) Strontium titanate ($SrTiO_3$) is deposited on a metallic substrate by laser ablation with a high power pulsed laser to create a deposit layer. The deposit layer can be utilized as a high density capacitor by itself or the deposit layer can be subsequently laser treated with a $CO_2$ laser beam to form a buffer layer such that a layer of superconductor can be later deposited on top of the buffer layer to create a highly conductive superconductor.

*FIG. 2*

## Background of the Invention

### Field of the Invention

This invention relates to strontium titanate, herinafter referred to as $SrTiO_3$, films of the type produced by laser ablation that are oriented so that the film's (100) face is parallel to the surface plane of the substrate. Such structures of this type, generally allow the $SrTiO_3$ film to be deposited such that a high density capacitor or a buffer layer for a superconductor can be created.

### Description of Related Art

There is a practical limitation of high transition temperature superconducting materials, hereinafter referred to as Hi-Tc materials, or the temperature at which the superconductor becomes superconductive especially in the use of ceramics in a superconductor. Modified perovskites exhibit excellent superconductive properties but are brittle and cannot sustain any tensile strains. Such tensile strains develop, for example, when the superconductor is wrapped around a bobbin to form a superconductive winding. It would then be desirable to mount the Hi-Tc material on a metal backing which could withstand the tensile strains, then in applications such as superconductive windings, the conductor could be wound while keeping the Hi-Tc ceramic material on the neutral axis which should be practically strain free.

Prior to the present invention, it was known in the production of substrates for superconductors to employ the use of a single crystal of a perovskite material such as $SrTiO_3$. Such single crystals may even attain the size of up to 4" in diameter. However, such single crystal substrates are impractical when being applied to superconductive windings because the single crystal can neither be grown long enough nor continuously wound on bobbins to fabricate magnets. Also, single crystals cannot be strung together conveniently to form an electrically continuous winding.

In another area concerning the production of buffer layers on a superconductive winding, a thin film of barium fluoride ($BaF_2$) was used as a buffer layer between the metal substrate and the superconducting film. While the $BaF_2$ buffer improved the superconducting properties of a $YBa_2Cu_3O_{7-x}$ superconductor, hereinafter referred to as YBCO, the superconducting properties of the YBCO could be further improved if the buffer layer was constructed of a material, preferably, a perovskite, which is more compatible with the YBCO, which can be classified as a modified perovskite.

RF sputtering of a target material onto a substrate to create a buffer layer for a superconductor or a high density capacitor has been tried as evidenced by the related U.S. Patent Application Serial No. 678,407 filed 1 April 1991. However with the RF sputtering technique, a atmosphere containing "heavy" ions, such as argon ions, is needed in order to adequately "knock" the molecules off a target of $SrTiO_3$. Consequently, one is limited in the variety of gases that can be employed in the RF sputtering technique.

Finally, no attempts have been made to employ a laser ablation process for depositing material on a substrate which material can act as both a buffer layer for a superconductor and a high density capacitor. Further, the use of a laser ablation process to deposit material which is more compatible with the superconductor and can be deposited to form relatively pure buffer layers for the superconductor and high density capacitors would be still more advantageous.

It is apparent from above that there exists a need in the art for a laser ablatable material which increases the superconductivity of the superconductive winding, and which can at least be deposited at the same deposition rates as known laser ablatable materials, but which at the same time can create either a buffer layer for the superconductor or a high density capacitor such that the buffer layer or capacitor are relatively pure compositions of the ablated material. It is a purpose of this invention to fulfill this and other needs in the art in a manner more apparent to the skilled artisan once given following disclosure.

## Summary of the Invention

Generally speaking, this invention fulfills these needs by providing a method for creating a thin film or a buffer layer on a tape substrate comprising the steps of depositing a portion of a target of strontium titanate on said substrate by ablation to form a deposit layer having crystals on said substrate, and impinging a localized heat source beam on said layer to cause increased alignment of said crystals. Further, a superconductor is formed by depositing a superconductor material on said buffer layer.

In certain preferred embodiments the substrate is a metal such as molybdenum, stainless steel or copper and the target material is made of $SrTiO_3$. Those practiced in the art will recognize that the principles can be used with other target materials such as potassium tantalate ($KTaO_3$) although the individual steps may be modified. The laser beam, which is employed is created by a Excimer or UV laser (in the preferred embodiment operating at either a 193 or 250 nanometer wavelength). If it is desired to produce a high density capacitor, the steps of impinging the $CO_2$ laser beam on the buffer layer and depositing a superconductor material on said layer are omitted.

In another further preferred embodiments, the $SrTiO_3$ is deposited on an substrate by the laser ablation process such that the (100) face of the $SrTiO_3$ molecule is parallel to the surface plane of the substrate which assists in properly orienting the c-axis of the superconductor which is later deposited on top of the buffer layer and, additionally, properly aligns the deposited $SrTiO_3$ molecule to create a high density capacitor.

In particularly preferred embodiments, the method of forming a buffer layer of this invention consists essentially of a tape of metal substrate which is cleaned, the substrate is then coated by laser ablation with a deposit of $SrTiO_3$ to create a buffer layer, the buffer layer is cooled, and the buffer layer is impinged with a laser beam of a $CO_2$ laser to more accurately align the (100) face of the buffer layer with respect to the surface plane of the substrate which then should properly align the c-axis of the superconductor. If a high density capacitor is desired, the step of impinging the buffer layer with the $CO_2$ laser may be omitted.

The preferred laser ablation deposition method according to this invention, offers the following advantages: improved hospitality to superconducting perovskite on the buffer layer: good capacitance characteristics of the capacitor; excellent economy; good safety characteristics; excellent versatility; and ease of operation. In fact, in many of the preferred embodiments, these factors of improved hospitality to superconducting properties, economy, and versatility are optimized to a extent considerably higher than heretofore achieved in prior, known deposition methods.

## Brief Description of the Drawings

The above and other features of the present invention which will become more apparent as the description proceeds are best understood by considering the following detailed description in conjunction with the accompanying drawings wherein like numbers represent like parts through several views and in which:

Figure 1 is a schematic drawing of a deposited buffer layer with the (100) face parallel to the surface plane of the substrate and the YBCO with its c-axis normal to the surface of the substrate deposited on top;

Figure 2 is a schematic drawing of a laser ablation process, according to the present invention;

Figure 3 is a detailed drawing, of the substrate being coated in the laser ablation chamber;

Figure 4 is a schematic drawing of the laser treatment of the buffer layer, according to the present invention;

Figures 5a and 5b are graphical representations of the (100) orientation of the of the $SrTiO_3$ deposited layer prior to and after laser treatment, respectively;

Figure 6 is a photographic presentation of the $SrTiO_3$ layer after being deposited on the substrate.

## Detailed Description of the Invention

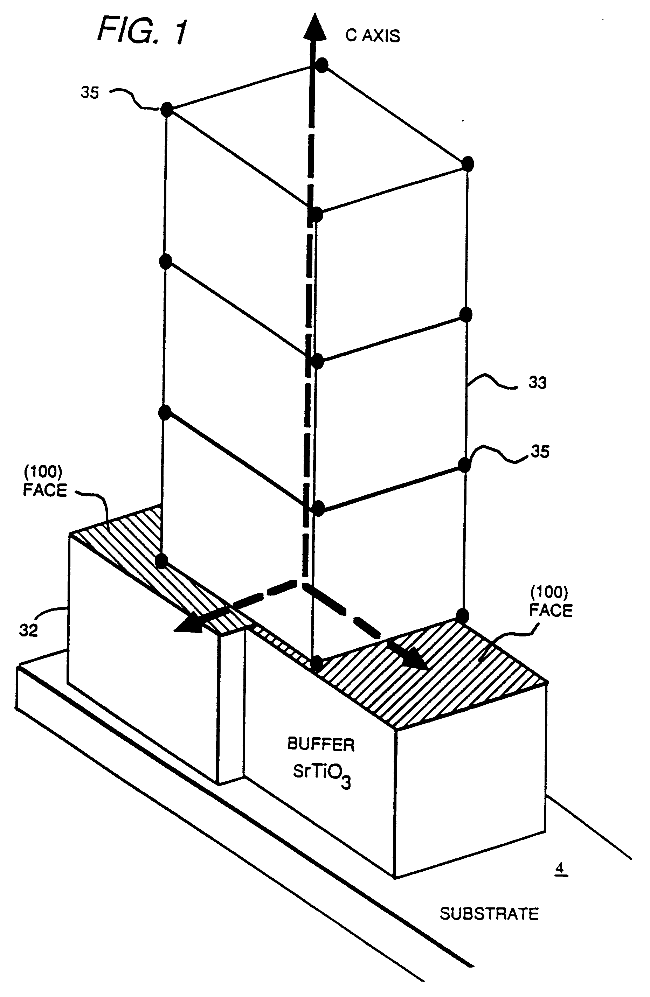

With reference first to Figure 1, there is illustrated a schematic drawing of a buffer layer of $SrTiO_3$ 32 after being deposited upon a substrate 4 with a layer 33 of YBCO superconductor material deposited on top of the buffer layer 32. The orientation of the (100) face with respect to the substrate surface can be discerned, in that, the (100) face of the buffer is parallel to the plane of the substrate surface upon which the buffer layer is located. The (100) face becomes oriented in this manner due to the inherent nature of the molecular structure of the $SrTiO_3$ as it is deposited on the surface of substrate during the laser ablation process.

With respect to the YBCO superconductor, the c-axis of the superconductor is oriented upwardly from the substrate surface. The c-axis is positioned upwardly due to the inherent nature of the YBCO superconductor as it is deposited on the hospitable buffer layer. It is important to recognize that in order for the YBCO superconductor to properly conduct electricity, the planes 35 of copper (Cu) atoms contained within the adjacent YBCO crystal lattice structures must line up along the length of the YBCO layer. The proper alignment of the (100) face of the $SrTiO_3$ provides a buffer layer which allows the YBCO superconductor to be deposited upon the buffer layer such that the planes 35 of Cu atoms are aligned. In order to even further increase precision of the alignment of the planes 35 of Cu atoms prior to deposition of the YBCO superconductor, the buffer layer is treated with a localized heat source, for example, a laser beam of a $CO_2$ laser which more precisely orients the (100) face of the buffer. However, if it is desired to only create a high capacitance capacitor, then the laser treatment and deposition of the YBCO superconductor can be omitted. A more specific discussion of the capacitor and laser treatment of the buffer layer are described below.

Finally, regarding the YBCO superconductor, the YBCO can be classified as a modified perovskite while $SrTiO_3$ is materially classified as a perovskite. Thus, when the YBCO is deposited upon the $SrTiO_3$, the interface between the two compounds remains relatively stable which keeps the planes 35 of Cu atoms of the YBCO in proper alignment along the length of the superconductor.

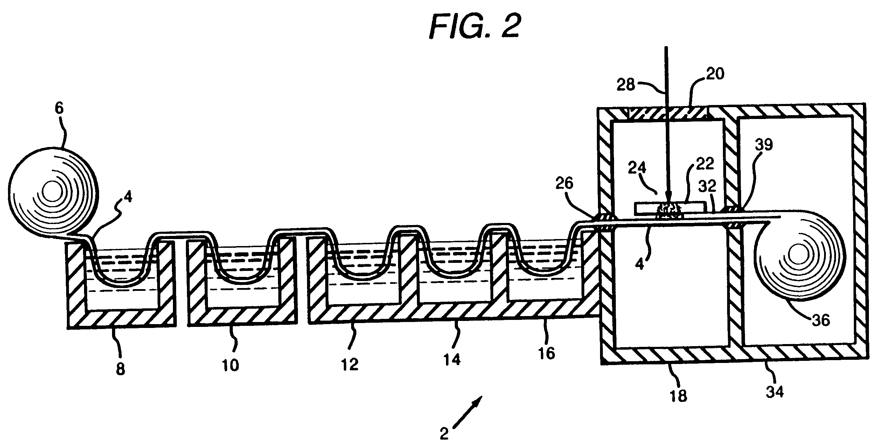

With respect to Figure 2, ablation apparatus 2 for depositing $SrTiO_3$ on a substrate 4 is shown. Apparatus 2 is, preferably, carried out with UV a laser. Tape substrate 4 is, preferably, any suitable metallic substrate, such as copper, stainless steel or molybdenum is initially wound on coil 6. In order to clean substrate 4, coil 6 is unwound and substrate 4 is conventionally degreased by any suitable Freon® solvent in degreasing vat 8. Substrate 4 is then passed through an electropolishing station 10 where substrate 4 is electropolished by materials appropriate for the particular metal substrate such that, preferably, there are no scratches greater than 45Å in substrate 4. Next, substrate 4 is subjected to ultrasonic cleaning station 12 where substrate 4 is ultrasonically cleaned by, preferably, de-ionized water. The ultrasonic cleaning in station 12 is followed by another ultrasonic cleaning station 14 where substrate 4 is further ultrasonically cleaned by, preferably, acetone. The ultrasonic cleaning in station 14, preferably, is carried out for approximately 20 minutes. Finally, substrate 4 passes through another ultrasonic cleaning station 16, where substrate 4 is ultrasonically cleaned by, preferably, methanol, for approximately 10 minutes.

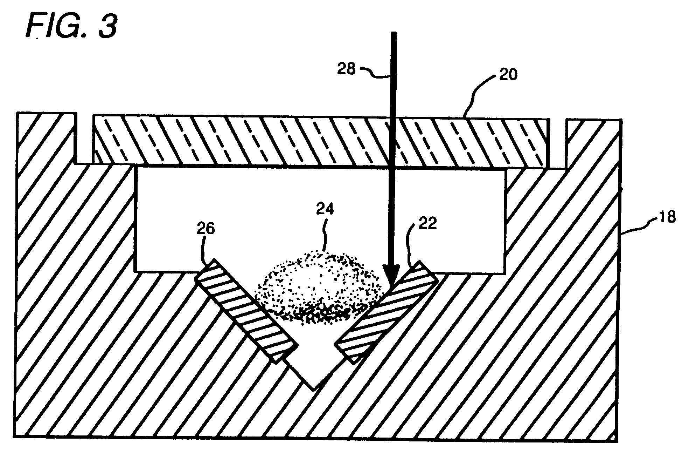

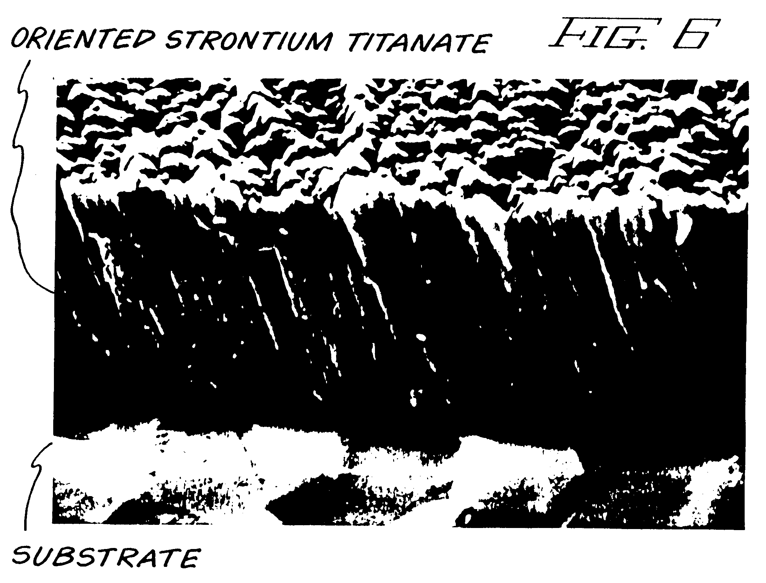

With respect to Figures 2 and 3, after substrate 4 has been cleaned, substrate 4 passes through a conventional vacuum seal 26 into laser ablation chamber 18. In chamber 18, gases, preferably, helium or oxygen enriched gases, such as Argon enriched with oxygen, are introduced into chamber 18 by a conventional gas transporting apparatus. A laser beam 28 from a conventional high power pulsed UV laser source (not shown), for example, an excimer laser operating preferably at a 193 or 250 nanometer wavelength passes through a window 20, which is, preferably, constructed of UV grade quartz or other suitable material transparent to UV light and impinges on target 22. Target 22, preferably, is constructed of $SrTiO_3$. As beam 28 impinges on target 22, plume 24 of $SrTiO_3$ particles is created. Particles from plume 24 are transported across the gap between substrate 26 and target 22 by the large amount of kinetic energy produced in the particles as laser beam 28 impinges target 22. The particles from plume 24 that traverse the gap between target 22 and substrate 26, are deposited on substrate 26 to create deposit layer 32. Finally, substrate 4 with deposit layer 32 moves past a conventional high vacuum seal 38 and into a conventional evacuated cooling chamber 34 where substrate 4 is cooled in chamber 34 for approximately 5 hours. After substrate 4 is cooled, it is rolled by conventional rolling techniques into roll 36. The resulting deposited 32 film is polycrystalline. If the film 32 is thick enough, roughly more than one (1) micron thick, the morphology of the upper parts of film 32, regardless of the structure near substrate 4, is columner with the (100) face parallel to the plane of the substrate surface. In other words, $SrTiO_3$ films of sufficient thickness, on metallic substrates, have a strong preference to grow with the (100) face parallel to the plane of the substrate. This tendency, of columner grains of crystals stacked with the (100) faces oriented parallel to the flat face of the substrate, is preferred over any other orientation after deposition on the substrate surface. These results are illustrated in Figure 6 which shows a representative film of $SrTiO_3$ deposited on a molybdenum substrate.

It is to be understood that the process for creating deposit layer 32 on substrate 4 can be adapted for batch production with a few minor changes. In particular, substrate 4 would have to be cut into pieces of a suitable length and width. Also, the pieces would have to be placed step by step into each of the chambers 8, 10, 12, 14, 16, 18 and 34. Finally, vacuum seals 38 and 26 may not be necessary because there is no need to insure the vacuum and integrity of chamber 24.

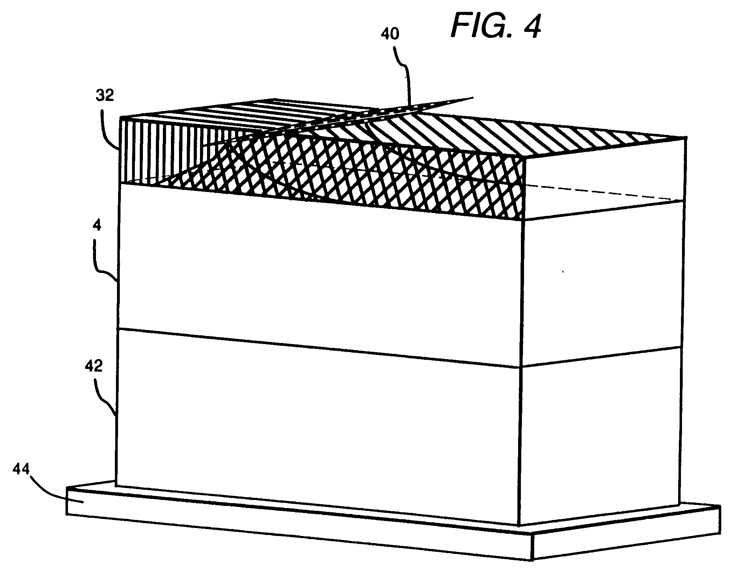

With respect to Figure 4, when it is desired to create a buffer layer from deposited layer 32, deposited layer 32 must be impinged by, preferably, a laser beam 40 from a conventional 1000W $CO_2$ laser (notshown). In particular, substrate 4 with deposited layer 32 is mounted on a conventional heater block 42 which, in turn, is mounted on a conventional X-Y traverse 44. Laser beam 40 is then impinged upon layer 32 at a wavelength, preferably, of about 10μm so that the (100) faces of all of the $SiTiO_3$ molecules in the layer 32 are more precisely oriented with respect to substrate 4 such that the (100) faces are fairly precisely parallel to the plane of the surface of substrate 4 upon which layer 32 is deposited. This laser treatment further increases the precision of the orientation of the (100) faces of layer 32.

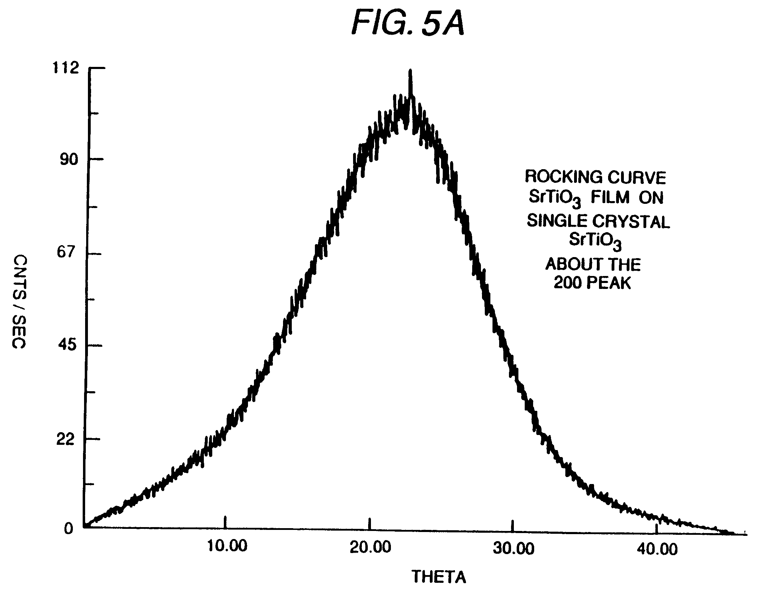

Figure 5a shows a standard rocking curve for a $SrTiO_3$ film about the (200) peak. The rocking curve was measured around the strong peak of (200). However, the (100) behavior is essentially the same. A scan be seen, prior to laser treatment, a majority of the $SrTiO_3$ deposit has a lattice structure whose angular orientation (theta) with respect to the substrate surface is distributed with a peak around 22°. Consequently, when the YBCO is deposited on layer 32, the randomness of the orientation of the (100) faces of the $SiTiO_3$ layer may create a lack of alignment of the c-axis in the YBCO layer which can, ultimately, affect the superconductive properties of the YBCO layer.

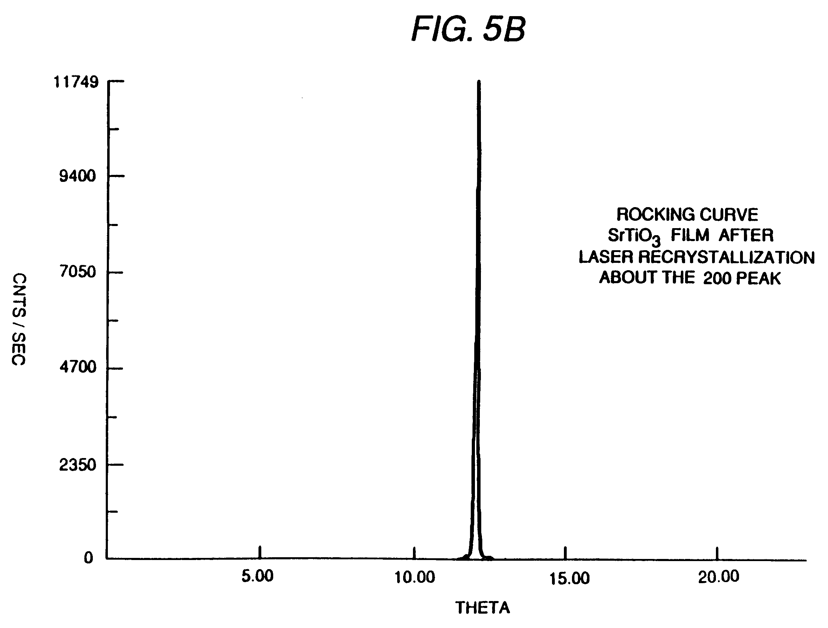

Figure 5b shows that once once layer is recrystallized by localized transient heating, the lack of uniformity of the orientation of the (100) faces virtually disappears. It so happened that the measurement after recrystallization was carried around the (100) peak, but the behavior of the (200) peak is the same. In particular, Figure 5b shows that after recrystallization, the rocking curve about the (100) peak of almost all of the $SiTiO_3$ film is concentrated around 12° with a very narrow spread therefrom. In production of the recrystallized film as shown in Figure 5b, a preferred localized heat source is used which consists of a $CO_2$ laser with output at 10.6 $\mu$m. The $CO_2$ laser is advantageous because it provides an intense controllable pattern that is strongly absorbed by $SrTiO_3$. Consequently, this improvement in orientation allows the YBCO molecules in superconductor layers to fairly accurately align along the length of the YBCO layer and increase the superconductive properties of the YBCO layer.

On the other hand, in order to produce a high density capacitor, layer 32 need not be laser treated. The capacitance properties of layer 32 as originally manufactured prior to laser treatment are sufficient to create a high density capacitor. In fact, the dielectric constant parallel to the axis normal to the (100) face (for simplicity we refer to this as the c-axis) of a $SiTiO_3$ molecule (190 at 26 degrees K and 100 KHz) is approximately twice the value along either of the other axes (85 for the same conditions imposed on the c-axis).

One of the unique features of this invention is that molecular structure the $SrTiO_3$ is such that the $SrTiO_3$ is capable of being initially laser treated with laser ablation to create a buffer layer or a high density capacitor and subsequently laser treated with the $CO_2$ laser to further create a highly conductive superconductor substrate. This is because the $SrTiO_3$ has a strong absorption rate at the wavelength where the excimer and $CO_2$ lasers operate, which are approximately 0.2$\mu$m and 10.6$\mu$m, respectively.

Once given the above disclosure, many other features, modifications and improvements will become apparent to the skilled artisan including the use alternative perovskites such as $KTaO_3$. Such features, modifications and improvements are, therefore, considered to be a part of this invention, the scope of which is to be determined by the following claims.

**Claims**

1. A method for creating a buffer layer on a substrate for a superconductor which is comprised of the steps of:
   depositing a portion of a target of strontium titanate on said substrate by ablation to form a deposit layer having crystals on said substrate; and
   impinging a localized heat source on said deposit layer to cause increased alignment of said crystals.

2. The method for creating a buffer layer on a substrate, according to claim 1, wherein said method is further comprised of the steps of:
   cleaning said substrate;
   polishing said substrate; and
   cooling said deposit layer and substrate.

3. The method for creating a buffer layer on a superconductor, according to claim 2, wherein said cleaning of said cleaning is further comprised of the steps of:
   degreasing said substrate; and
   ultrasonically cleaning said substrate.

4. The method for creating a buffer layer on a substrate, according to claim 2, wherein said polishing of said substrate is further comprised of the step of:
   electropolishing said substrate.

5. The method for creating a buffer layer on a substrate, according to claim 1, wherein said localized heat source is further comprised of:
   a laser beam.

6. The method for creating a buffer layer on a substrate, according to claim 1, wherein said depositing of said portion of said target on said substrate is further comprised of the steps of:
   impinging a laser beam from a high power pulsed laser;
   creating a plume of particles of strontium titanate; and
   depositing said particles of strontium titanate on said substrate.

7. The method for creating a buffer layer on a substrate, according to claim 1, wherein said impinging of said laser beam on said deposit layer is further comprised of the steps of:
   directing a laser beam from a $CO_2$ laser source onto a portion of said deposit layer;
   impinging said portion of said deposit layer with said laser beam; and
   orienting a molecular face of said deposit layer.

8. A method for creating a high density capacitor having a substrate which is comprised of the step of:
   depositing a portion of a target of strontium titanate on said substrate by ablation to form a deposit layer having crystals on said substrate.

**9.** The method for creating a high density capacitor, according to claim 8, wherein said method is further comprised of the steps of:

cleaning said substrate;

polishing said substrate;

etching said substrate; and

cooling said deposit layer.

**10.** The method for creating a high density capacitor, according to claim 9, wherein said cleaning of said substrate is further comprised of the steps of:

degreasing said substrate; and

ultrasonically cleaning said substrate.

**11.** The method for creating a high density capacitor, according to claim 9, wherein said polishing of said substrate is further comprised of the step of:

electropolishing said substrate.

**12.** The method for creating a high density capacitor, according to claim 8, wherein said depositing of said portion of said target on said substrate is further comprised of the steps of:

impinging a laser beam from a high pulsed laser;

creating a plume of particles of strontium titanate; and

depositing said particles of strontium titanate on said substrate.

**13.** A method for creating a superconductor having a metallic substrate with first and second sides, a buffer layer having first and second sides, a target of strontium titanate, and a superconductor layer of $YBa_2Cu_3O_{7-x}$ having first and second sides which is comprised of the steps of:

depositing a portion of said target of strontium titanate by ablation on said second side of said substrate to create said buffer layer having crystals;

impinging a localized heat source on said second side of said buffer layer to cause increased alignment of said crystals; and

depositing said superconductive layer on said second side of said buffer layer.

**14.** The method for creating a superconductor, according to claim 13, wherein said method is further comprised of the steps of:

cleaning said substrate;

polishing said substrate; and

cooling said buffer layer and substrate.

**15.** The method for creating a superconductor, according to claim 13, wherein said localized heat source is further comprised of:

a laser beam.

*FIG. 1*

C AXIS

35

33

35

(100)
FACE

(100)
FACE

32

BUFFER
SrTiO$_3$

4

SUBSTRATE

FIG. 2

EP 0 512 679 A2

FIG. 3

EP 0 512 679 A2

FIG. 4

32
40
4
42
44

EP 0 512 679 A2

FIG. 5A

ROCKING CURVE
SrTiO$_3$ FILM ON
SINGLE CRYSTAL
SrTiO$_3$
ABOUT THE
200 PEAK

THETA

CNTS / SEC

11

# FIG. 5B

ROCKING CURVE
SrTiO$_3$ FILM AFTER
LASER RECRYSTALLIZATION
ABOUT THE 200 PEAK

CNTS / SEC

THETA

EP 0 512 679 A2

FIG. 6

ORIENTED STRONTIUM TITANATE

SUBSTRATE